# EUROPÄISCHE PATENTANMELDUNG

(11) **EP 2 075 792 A2**
(43) Veröffentlichungstag der Anmeldung: **01.07.2009**
(21) Anmeldenummer: 08172870.1
(22) Anmeldetag: 23.12.2008
(51) Int. Cl.: G11B 20/10, H03M 1/10

(54) **Vorrichtung und Verfahren zur Korrektur von Signalverzerrungen**

(30) Priorität: 27.12.2007 DE 102007062752
(71) Anmelder: Burmester Audiosysteme GmbH, 10829 Berlin (DE)
(72) Erfinder: Van der Grinten, Martin, 12459 Berlin (DE); Bergmann, Nico, 13088 Berlin (DE); Größler, Stefan, 12459 Berlin (DE)
(74) Vertreter: Zimmermann & Partner

(57) **Zusammenfassung**

Ein Verfahren zur Korrektur von Signalverzerrungen wird bereitgestellt, wobei das Verfahren die Schritte Einlesen eines digitalen Eingangssignalwerts, Bestimmen eines digitalen Ausgangssignalwerts anhand des eingelesenen digitalen Eingangssignalwerts, und Ausgeben des digitalen Ausgangssignalwerts an eine Signalverarbeitungsstrecke umfaßt, wobei der digitale Ausgangssignalwert so bestimmt wird, daß ein vorbestimmter systematischer Fehler einer Signalverarbeitung durch die Signalverarbeitungsstrecke bezüglich des digitalen Eingangssignalwerts kompensiert wird.

## Beschreibung

Die vorliegende Erfindung betrifft eine Vorrichtung und ein Verfahren zur Korrektur von Signalverzerrungen sowie ein Verfahren zur Herstellung einer solchen Vorrichtung.

Audiosignale und Videosignale werden inzwischen hauptsächlich in digitaler Form gespeichert. Typische Speichermedien sind beispielsweise die CD und die DVD, jedoch sind auch beliebige andere digitale Datenträger zur Speicherung der Signale geeignet. Bei einer Wiedergabe der digitalen Signale müssen diese jedoch wieder in analoge Signale gewandelt werden. Beispielsweise wird das von einer CD ausgelesene digitale Audiosignal vor der Verstärkung in ein analoges Signal gewandelt. Diese Wandlung erfolgt mittels eines DigitallAnalog-Wandlers (D/A-Wandlers), der im Stand der Technik bekannt ist. Solche D/A-Wandler weisen Fehler, insbesondere Linearitätsfehler, Monotoniefehler und auch Offsetfehler, auf. Mit anderen Worten, vergleicht man das am analogen Ausgang des D/A-Wandlers ausgegebene analoge Signal mit dem digitalen Eingangssignal, so stellt man typischerweise fest, daß der analoge Ausgang stets eine minimale Spannung, die sogenannte Offset-Spannung, aufweist und die Kennlinie des D/A-Wandlers im weiteren Verlauf nichtlinear und nicht unbedingt monoton ist. Aufgrund dieser Fehler ist das am analogen Ausgang des D/A-Wandlers ausgegebene Signal gegenüber dem digitalen Eingangssignal verzerrt. Eine weitere Signalverzerrung erfolgt beispielsweise durch die nachfolgende Verstärkung des analogen Audiosignals. Somit ist das ausgegebene analoge Signal gegenüber dem vom digitalen Datenträger ausgelesenen digitalen Signal verzerrt. Eine solche Verzerrung kann beispielsweise bei Audiosignalen hörbar sein und somit zu einer verfälschten Wiedergabe des Originalklangs führen.

Im Hinblick auf die oben genannten Nachteile des Standes der Technik schlägt die vorliegende Erfindung ein Verfahren gemäß Anspruch 1 sowie eine Korrekturvorrichtung gemäß Anspruch 13 vor. Darüber hinaus schlägt die vorliegende Erfindung eine Vorrichtung zum Verarbeiten eines digitalen Audiosignals gemäß Anspruch 19 sowie ein Herstellungsverfahren für eine solche Vorrichtung gemäß Anspruch 21 vor. Weitere Aspekte, Vorteile und Einzelheiten der vorliegenden Erfindung ergeben sich aus den Unteransprüchen, der Beschreibung sowie den beigefügten Zeichnungen.

Gemäß einem ersten Ausführungsbeispiel der vorliegenden Erfindung wird ein Verfahren zur Korrektur von Signalverzerrungen bereitgestellt, bei dem ein digitaler Eingangssignalwerts eingelesen, ein digitaler Ausgangssignalwerts anhand des eingelesenen digitalen Eingangssignalwerts bestimmt, und der digitale Ausgangssignalwerts an eine Signalverarbeitungsstrecke ausgegeben wird. Dabei wird der digitale Ausgangssignalwert so bestimmt, daß ein vorbestimmter systematischer Fehler einer Signalverarbeitung durch die Signalverarbeitungsstrecke bezüglich des digitalen Eingangssignalwerts kompensiert wird.

Aufgrund des obigen Korrekturverfahrens können bekannte systematische Fehler der nachfolgenden Signalverarbeitungsstrecke kompensiert werden. Dabei wird die Kompensation derart vorgenommen, daß der eingelesene digitale Eingangswert durch einen digitalen Ausgangswert ersetzt wird, der nach Durchlaufen der nachfolgenden Signalverarbeitungsstrecke und den dabei systematisch auftretenden Fehlern zu einem (analogen) Ausgangssignal führt, das dem digitalen Eingangssignal entspricht. Es wird also die Kenntnis der systematischen Fehler der Signalverarbeitungsstrecke ausgenutzt, indem das in die Signalverarbeitungsstrecke eingespeiste digitale Signal diese Fehler schon berücksichtigt. Somit entspricht das von der Signalverarbeitungsstrecke ausgegebene Signal dem ursprünglichen Eingangssignal.

Gemäß einem weiteren Ausführungsbeispiel wird der vorbestimmte systematische Fehler mittels einer Übertragungsfunktion der Signalverarbeitungsstrecke bestimmt. Beispielsweise kann dazu die Übertragungsfunktion der Signalverarbeitungsstrecke vor Durchführung des Korrekturverfahrens gemessen werden.

Gemäß noch einem Ausführungsbeispiel werden die digitalen Ausgangssignalwerte in Form einer Look-Up-Tabelle bereitgestellt. Insbesondere kann dabei der digitale Eingangssignalwert als Indexwert der Look-Up-Tabelle verwendet werden.

Auf diese Weise ist eine besonders schnelle Durchführung des Korrekturverfahrens möglich, da keinerlei Berechnungen erforderlich sind. Die Information über die systematischen Fehler der Signalverarbeitungsstrecke ist in diesem Fall vollständig in der Look-Up-Tabelle codiert.

Gemäß einem weiteren Ausführungsbeispiel kann der vorbestimmte systematische Fehler zumindest einen systematischen Fehler einer Wandlung eines digitalen Signalwerts in ein analoges Signal beinhaltet. Insbesondere kann der systematische Fehler der Wandlung des digitalen Signalwerts in ein analoges Signal einen Offsetfehler und/oder einen Linearisierungsfehler und/oder einen Monotoniefehler umfaßt. Gemäß einem Ausführungsbeispiel umfaßt das Verfahren weiterhin das Umwandeln des digitalen Ausgangssignalwerts in ein analoges Signal.

Wie bereits anfänglich ausgeführt muß ein digitales Eingangssignal schließlich in ein analoges Ausgangssignal gewandelt werden, um beispielsweise als Klang über Lautsprecher ausgegeben werden zu können. Daher ist eine Wandlung von digitalen Signalen in analoge Signale ein typischer Anwendungsfall, bei dem solche systematischen Fehler auftreten können.

Gemäß einer Weiterbildung der vorliegenden Erfindung kann der vorbestimmte systematische Fehler zumindest einen systematischen Fehler einer Verstärkung eines aus dem digitalen Ausgangssignal erhaltenen analogen Signals beinhaltet. Insbesondere kann dabei der systematische Fehler der Verstärkung des analogen Signals eine nichtlineare Verzerrung umfassen. Gemäß einem Ausführungsbeispiel kann daher das Korrekturverfahren weiterhin das Verstärken eines aus dem digitalen Ausgangssignalwert erhaltenen analogen Signals beinhalten.

Auf diese Weise können nicht nur systematische Fehler bei der D/A-Wandlung des Eingangssignals sondern auch Fehler bei der nachfolgenden Verstärkung des analogen Signals kompensiert werden. Auf diese Weise kann beispielsweise für digitale Audiodaten, z.B. Musik, erreicht werden, daß der schließlich von einem Lautsprecher ausgegebene Klang möglichst ähnlich zu den beispielsweise von einer CD eingelesenen Audiodaten ist.

Gemäß einem weiteren Ausführungsbeispiel der vorliegenden Erfindung wird eine Vorrichtung zur Korrektur von Signalverzerrungen bereitgestellt, die Mittel zum Einlesen eines digitalen Eingangssignalwerts und Mittel zum Bestimmen eines digitalen Ausgangssignalwerts anhand des eingelesenen digitalen Eingangssignalwerts umfaßt. Dabei wird der digitale Ausgangssignalwert so bestimmt, daß ein vorbestimmter systematischer Fehler einer nachfolgenden Signalverarbeitung durch eine Signalverarbeitungsstrecke bezüglich des digitalen Eingangssignalwerts kompensiert ist. Weiterhin umfaßt die Vorrichtung Mittel zum Ausgeben des digitalen Ausgangssignalwerts an die Signalverarbeitungsstrecke.

Mittels der oben beschriebenen Vorrichtung können bekannte systematische Fehler einer der Vorrichtung nachgeschalteten Signalverarbeitungsstrecke kompensiert werden. Dabei ist die Vorrichtung so eingerichtet, daß der eingelesene digitale Eingangswert durch einen digitalen Ausgangswert ersetzt wird, der nach Durchlaufen der nachgeschalteten Signalverarbeitungsstrecke und den dabei systematisch auftretenden Fehlern zu einem (analogen) Ausgangssignal führt, das dem digitalen Eingangssignal entspricht. Die Vorrichtung nutzt also die Kenntnis der systematischen Fehler der nachgeschalteten Signalverarbeitungsstrecke aus, indem das in die Signalverarbeitungsstrecke eingespeiste digitale Signal schon so verschoben ist, daß die nun auf das verschobene Signal einwirkenden Fehler zu einem Ausgangssignal führen, das dem ursprünglichen Eingangssignal entspricht.

Gemäß einem Ausführungsbeispiel der vorliegenden Erfindung ist die Vorrichtung ein Mikrocontroller. Jedoch kann die vorliegende Erfindung auch mittels einem Mikroprozessor oder einem digitalen Signalprozessor realisiert werden.

Gemäß einer Weiterbildung der vorliegenden Erfindung ist eine Abschirmung vorgesehen, die eine ungewollte Beeinflussung der Vorrichtung durch ein Taktsignal weitgehend verhindert. Beispielsweise kann die Abschirmung ein Metallgehäuse umfaßt.

Auf diese Weise kann effektiv verhindert werden, daß ein hochfrequentes Taktsignal einstreut und so die Funktionsfähigkeit der Korrekturvorrichtung beeinträchtigt.

Gemäß Weiterbildungen der vorliegenden Erfindung können das Korrekturverfahren sowie die zugehörige Korrekturvorrichtung insbesondere bei CD-Playern, DVD-Playern, Vorverstärkern, Vollverstärkern, Surround-Prozessoren, digitalen Tunern, DVBT-Tunern, DAB-Tunern, SACD-Playern sowie HD-DVD-Playern vorteilhaft eingesetzt werden. Ebenfalls können das Korrekturverfahren sowie die zugehörige Korrekturvorrichtung bei Abspielgeräten nach dem BluRay^{®}-Standard eingesetzt werden.

Gemäß einem Ausführungsbeispiel der vorliegenden Erfindung umfaßt ein Herstellungsverfahren für eine Vorrichtung zum Verarbeiten eines digitalen Audiosignals das Bereitstellen eines vorbestimmten Testsignals an eine Signalverarbeitungsstrecke, das Bestimmen eines von der Signalverarbeitungsstrecke anhand des Testsignals erzeugten Ausgangssignals, das Ermitteln eines systematischen Fehlers der Signalverarbeitungsstrecke anhand des Testsignals und des Ausgangssignals, das Bestimmen einer Zuordnung zwischen digitalen Eingangssignalwerten und digitalen Ausgangssignalwerten, so daß der ermittelte systematische Fehler der Signalverarbeitungsstrecke bezüglich des digitalen Eingangssignalwerts durch den digitalen Ausgangssignalwert kompensiert wird, und das Bereitstellen der bestimmten Zuordnung in der Vorrichtung zur Korrektur von Signalverzerrungen. Insbesondere kann dabei der systematische Fehler mittels einer Übertragungsfunktion der Signalverarbeitungsstrecke bestimmt werden. Gemäß einer Weiterbildung kann die Zuordnung in Form einer Look-Up-Tabelle bereitgestellt werden

Anhand der beigefügten Zeichnungen werden nun Ausführungsbeispiele der vorliegenden Erfindung erläutert. Dabei zeigt:
- Fig. 1: einen typischen systematischen Fehler, wie er durch ein Korrekturverfahren gemäß Ausführungsbeispielen der vorliegenden Erfindung kompensiert werden kann.
- Fig. 2: das Grundprinzip eines Korrekturverfahrens gemäß einem Ausführungsbeispielen der vorliegenden Erfindung.
- Fig. 3: eine schematische Darstellung einer Korrekturvorrichtung gemäß einem Ausführungsbeispiel der vorliegenden Erfindung.
- Fig. 4: ein Beispiel für eine Look-Up-Tabelle, wie sie gemäß Ausführungsbeispielen der vorliegenden Erfindung verwendet werden wird.
- Fig. 5: eine seitliche Schnittansicht einer Korrekturvorrichtung gemäß einem Ausführungsbeispiel der vorliegenden Erfindung.
- Fig. 6: ein Blockdiagramm einer Vorrichtung gemäß einem Ausführungsbeispiel der vorliegenden Erfindung.
- Fig. 7: ein Blockdiagramm einer Weiterbildung der in Fig. 6 gezeigten Vorrichtung gemäß einem Ausführungsbeispiel der vorliegenden Erfindung.

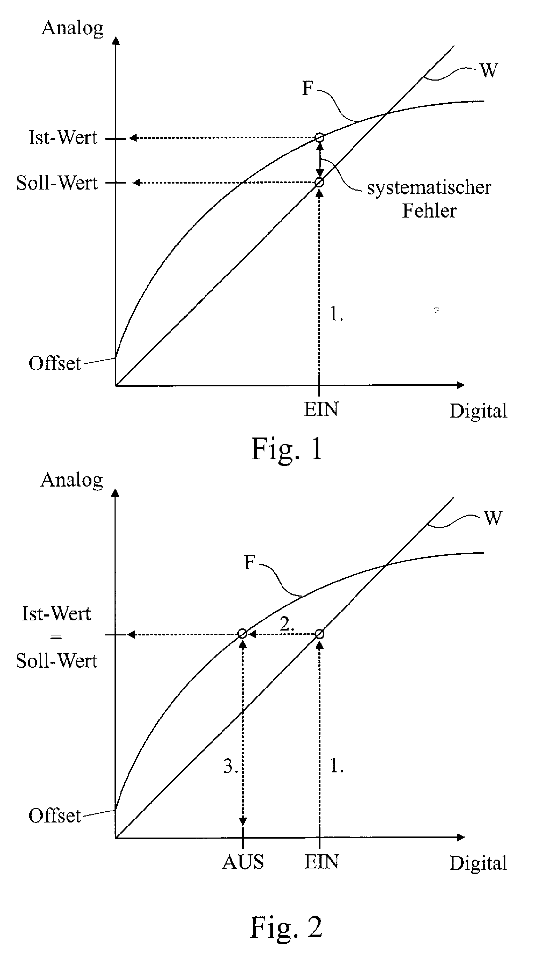

Fig. 1 zeigt beispielhaft einen systematischen Fehler, wie er durch ein Korrekturverfahren gemäß Ausführungsbeispielen der vorliegenden Erfindung kompensiert werden kann. Die Fehlerproblematik soll dabei beispielhaft anhand einer D/A-Wandlung beschrieben werden, ist aber grundsätzlich auch auf andere systematischen Fehler, die bei der Signalverarbeitung entstehen anwendbar. In Fig. 1 ist der Signalwert EIN eines digitalen Eingangssignals, beispielsweise eines von einer CD ausgelesenen digitalen Audiosignals, auf der Abszisse aufgetragen. Wäre nun die D/A-Wandlung fehlerfrei, so müßte sich der entsprechende analoge Ausgangswert durch Spiegelung des digitalen Eingangswertes EIN an der Winkelhalbierenden W auf der Ordinate ergeben. Da eine möglichst exakte D/A-Wandlung gewünscht ist, entspricht dieser an der Winkelhalbierende gespiegelte Ausgangswert einem Soll-Ausgangswert. Wie oben bereits dargestellt ist die tatsächliche D/A-Wandlung fehlerbehaftet. So weist eine D/A-Wandlung häufig einen Offset-Fehler auf, d.h. das Ausgangssignal ist um einen bestimmten festen Offset-Wert verschoben. Weiterhin ist die D/A-Wandlung häufig auch nichtlinear oder nicht monoton. Dies wird in Fig. 1 beispielhaft durch die Übertragungsfunktion F dargestellt. Wie aus Fig. 1 ersichtlich wird der digitale Signaleingangswert EIN durch die tatsächliche Übertragungsfunktion F der D/A-Wandlung auf einen Ist-Ausgabewert abgebildet, der um den systematischen Fehler verschoben ist.

Das Grundprinzip eines Korrekturverfahrens gemäß einem Ausführungsbeispielen der vorliegenden Erfindung wird nun anhand von Fig. 2 erläutert. Darin wird zunächst in einem ersten Schritt der digitale Signaleingangswert EIN an der Winkelhalbierenden W gespiegelt, um einen analogen Soll-Ausgabewert zu bestimmen. In einem zweiten Schritt wird nun der Punkt auf der tatsächlichen fehlerbehafteten Übertragungsfunktion F ermittelt, der ebenfalls diesen Soll-Ausgabewert liefert. Nun wird dieser Punkt auf der tatsächlichen fehlerbehafteten Übertragungsfunktion F zurück auf die Abszisse projiziert, um einen verschobenen digitalen Ausgangswert AUS zu finden. Wird nun dieser verschobene digitale Wert AUS der D/A-Wandlung unterworfen, so liefert die D/A-Wandlung einen analogen Ist-Ausgangswert, der dem Soll-Ausgangswert des ursprünglichen Signaleingangswertes EIN entspricht. Auf diese Weise können die systematischen Fehler der D/A-Wandlung aufgrund der Kenntnis der Übertragungsfunktion F durch ermitteln eines verschobenen digitalen Wertes AUS kompensiert werden. Insbesondere können auf diese Weise die bei der Wandlung des digitalen Signalwerts in ein analoges Signal auftretenden Offsetfehler und/oder Linearisierungsfehler und/oder Monotoniefehler kompensiert werden.

Das oben anhand einer D/A-Wandlung beispielhaft beschriebene Korrekturverfahren läßt sich selbstverständlich für jede Signalverarbeitungsstrecke anwenden, deren systematische Fehler, d.h. Abweichungen von der idealen Übertragungsfunktion, man kennt. Insbesondere ist das beschriebene Verfahren auch auf andere, insbesondere komplexere Übertragungsfunktionen als die hier beispielhaft dargestellte Identität (Winkelhalbierende) anwendbar. Durch das beschriebene Korrekturverfahren können daher die vorbestimmten systematischen Fehler einer Signalverarbeitung durch eine beliebige Signalverarbeitungsstrecke kompensiert werden.

Typischerweise wird bei Korrekturverfahren gemäß Ausführungsbeispielen der vorliegenden Erfindung der vorbestimmte systematische Fehler mittels einer Übertragungsfunktion der Signalverarbeitungsstrecke bestimmt. Dazu kann beispielsweise die Übertragungsfunktion der Signalverarbeitungsstrecke mittels eines Testsignals ausgemessen werden. Dabei wird ein vorbestimmtes Testsignal an die zu vermessende Signalverarbeitungsstrecke als Eingangssignal bereitgestellt und das von der Signalverarbeitungsstrecke anhand des Testsignals erzeugte Ausgangssignals gemessen. Anhand des Testsignals und des Ausgangssignals können dann systematische Fehler der Signalverarbeitungsstrecke z.B. anhand einer Übertragungsfunktion ermittelt werden. Anschließend kann die oben beschriebene Zuordnung zwischen digitalen Eingangssignalwerten und digitalen Ausgangssignalwerten erfolgen, so daß der ermittelte systematische Fehler der Signalverarbeitungsstrecke bezüglich des digitalen Eingangssignalwerts durch den digitalen Ausgangssignalwert kompensiert wird. Gemäß einer Ausführungsform der vorliegenden Erfindung kann die Zuordnung zwischen Eingangs- und Ausgangswerten in Form einer Look-Up-Tabelle erfolgen.

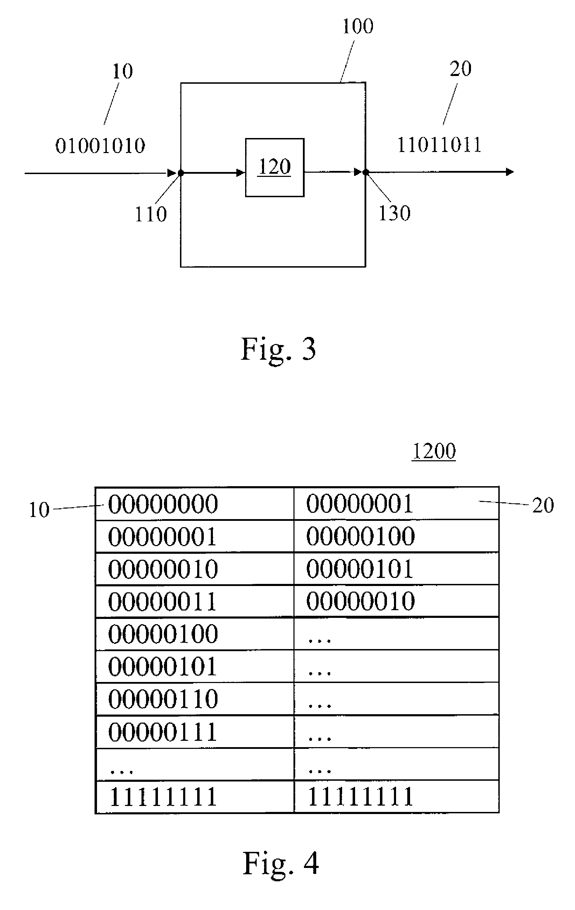

Fig. 3 zeigt eine schematische Darstellung einer Korrekturvorrichtung 100 gemäß einem Ausführungsbeispiel der vorliegenden Erfindung. Dabei umfaßt die Vorrichtung 100 zur Korrektur von Signalverzerrungen Mittel 110 zum Einlesen eines digitalen Eingangssignalwerts 10. Dieser digitale Eingangssignalwert kann beispielsweise ein digitales Audiosignal sein. Weiterhin umfaßt die Vorrichtung 100 Mittel 120 zum Bestimmen eines digitalen Ausgangssignalwerts 20 anhand des eingelesenen digitalen Eingangssignalwerts 10. Dabei wird der digitale Ausgangssignalwert 20 so bestimmt, daß ein vorbestimmter systematischer Fehler einer nachfolgenden Signalverarbeitung durch eine Signalverarbeitungsstrecke bezüglich des digitalen Eingangssignalwerts 10 kompensiert ist. Auf welche Weise eine solche Kompensation erfolgen kann, wurde bereits oben anhand der Fign. 1 und 2 erläutert. Weiterhin umfaßt die Korrekturvorrichtung 100 Mittel 130 zum Ausgeben des digitalen Ausgangssignalwerts 20 an die Signalverarbeitungsstrecke. Typischerweise sind die Mittel 120 zum Bestimmen des digitalen Ausgangssignalwerts als Mikrocontroller verwirklicht, jedoch können die Mittel 120 zum Bestimmen des digitalen Ausgangssignalwerts auch mittels eines Mikroprozessors oder eines digitalen Signalprozessors realisiert werden. Gemäß einem Ausführungsbeispiel werden dabei in dem Mittel 120 zum Bestimmen eines digitalen Ausgangssignalwerts mehrere digitale Ausgangssignalwerte 20 in Form einer Look-Up-Tabelle bereitgestellt.

Dies wird nun anhand von Fig. 4 näher erläutert. Figur 4 zeigt ein Beispiel für eine Look-Up-Tabelle 1200, wie sie gemäß Ausführungsbeispielen der vorliegenden Erfindung verwendet werden kann. Dabei ist jedem möglichen digitalen Eingangssignalwert 10 ein entsprechend verschobener Ausgangssignalwert 20 zugeordnet. Diese verschobenen Ausgangssignalwerte 20 können über das anhand von Fig. 2 beschriebene Verfahren z.B. durch Vermessen der Übertragungsfunktion F der Signalverarbeitungsstrecke aufgefunden werden. Gemäß einer Weiterbildung der vorliegenden Erfindung wird der digitale Eingangssignalwert 10 als Indexwert der Look-Up-Tabelle 1200 verwendet. Auf diese Weise kann die Zuordnung des verschobenen Ausgangssignalwerts 20 besonders einfach und schnell erfolgen, da keinerlei Berechnungen erforderlich sind. Die Information über die systematischen Fehler der Signalverarbeitungsstrecke ist in diesem Fall vollständig in der Look-Up-Tabelle 1200 codiert.

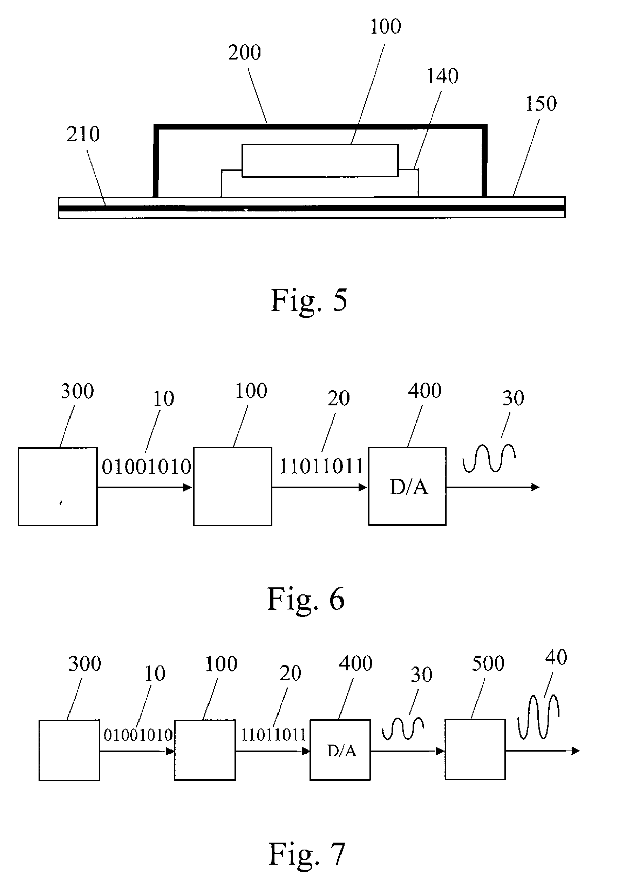

Fig. 5 zeigt eine seitliche Schnittansicht einer Korrekturvorrichtung 100 gemäß einem Ausführungsbeispiel der vorliegenden Erfindung. Dabei ist die Korrekturvorrichtung 100 als Mikrocontroller ausgebildet und mittels Anschlüssen 140 auf einer Leiterplatte 150 montiert. Die Korrekturvorrichtung 100 umfaßt weiterhin eine Abschirmung 200, 210, die eine ungewollte Beeinflussung der Korrekturvorrichtung 100 weitgehend verhindert. Insbesondere das Einstreuen von hochfrequenten Taktsignalen könnte die Funktion der Korrekturvorrichtung 100 nachteilig beeinflussen. Die Abschirmung umfaßt ein Metallgehäuse 200, das auf der Leiterplatte aufgesetzt ist und die Korrekturvorrichtung von fünf Seiten umschließt. Beispielsweise kann das Metallgehäuse 200 aus Kupfer sein. Gemäß einer Weiterbildung kann die Leiterplatte eine mehrlagige Leiterplatte, insbesondere eine 4-Lagen-Leiterplatte sein, wobei eine der mehreren Schichten eine metallische Abschirmschicht 210 ist. Auf diese Weise kann die Korrekturvorrichtung 100 auch von der Leiterplattenseite her gegen unerwünschte Einstreuung von störenden Signalen, beispielsweise Taktsignalen, geschützt werden.

Fig. 6 zeigt ein Blockdiagramm einer Vorrichtung zum Verarbeiten eines digitalen Audiosignals gemäß einem Ausführungsbeispiel der vorliegenden Erfindung. Die Vorrichtung umfaßt dabei Mittel 300 zum Bereitstellen eines digitalen Audiosignals 10. Eine solche Vorrichtung könnte beispielsweise eine Vorrichtung zum Auslesen digitaler Audiodaten in einem CD-Player, einem DVD-Player, einem Surround-Prozessor, einem digitalen Tuner, einem DVBT-Tuner, einem DAB-Tuner, einem SACD-Player sowie einem HD-DVD-Player sein. Ebenfalls könnte das Mittel in einem Abspielgerät nach dem BluRay^{®}-Standard bereitgestellt sein. Das Mittel 300 stellt das ausgelesene digitale Audiosignal 10 an eine Vorrichtung 100 zur Korrektur von Signalverzerrungen bereit. Weiterhin ist der Korrekturvorrichtung 100 eine Signalverarbeitungsstrecke 400 nachgeschaltet. Im dem in Fig. 6 angegebenen Beispiel ist die Signalverarbeitungsstrecke 400 ein D/A-Wandler, der ein analoges Audiosignal 30 ausgibt. Die Übertragungsfunktion F des D/A-Wandlers 400 ist bekannt, beispielsweise durch vorheriges Vermessen, und liegt in der Korrekturvorrichtung 100 in einer Look-Up-Tabelle 1200 codiert vor. Ein von dem Auslesemittel 300 an die Korrekturvorrichtung 100 bereitgestelltes Audioeingangssignal 10 wird daher von der Korrekturvorrichtung 100 in ein digitales Audioausgangssignal 20 umgesetzt. Dieses digitale Audioausgangssignal 20 stellt die Korrekturvorrichtung 100 nun an den D/A-Wandler 400 bereit, der das digitale Audioausgangssignal 20 in ein analoges Audiosignal 30 wandelt. Da die spezifischen Verzerrungen des D/A-Wandlers 400, z.B. Offsetfehler und/oder Linearisierungsfehler und/oder Monotoniefehler, bereits in dem von der Korrekturvorrichtung 100 ausgegebenen Ausgangssignal 20 berücksichtigt sind, entspricht das vom D/A-Wandler ausgegebene analoge Audiosignal 30 dem digitalen Eingangssignal 10.

Fig. 7 zeigt ein Blockdiagramm einer Weiterbildung der in Fig. 6 gezeigten Vorrichtung gemäß einem weiteren Ausführungsbeispiel der vorliegenden Erfindung. Dabei ist der grundsätzliche Aufbau gleich, jedoch umfaßt die Signalverarbeitungsstrecke neben dem D/A-Wandler 400 noch einen Verstärker 500, der das vom D/A-Wandler 400 ausgegebene analoge Audiosignal 30 verstärkt und das verstärkte Audiosignal 40 ausgibt. Beispielsweise kann der Verstärker 500 ein Vollverstärker sein und das verstärkte Audiosignal 40 an einen Lautsprecher ausgeben. Gemäß einem anderen Ausführungsbeispiel kann der Verstärker 500 ein Vorverstärker sein und das verstärkte Audiosignal 40 an eine Verstärker-Endstufe ausgeben. In jedem Fall ist zu beachten, daß auch der Verstärker 500 typischerweise nicht im gesamten Verstärkungsbereich vollständig linear arbeitet und somit Verzerrungen des verstärkten Ausgangssignals 40 zu dem analogen Verstärkereingangssignal 30 bewirkt. Diese durch den Verstärker verursachten Verzerrungen können, soweit sie systematischer Natur und vorab bekannt sind, ebenfalls durch die Korrekturvorrichtung 100 berücksichtigt werden. In diesem Fall ist das von der Korrekturvorrichtung 100 ausgegebene digitale Ausgangssignal 20 so gegenüber dem digitalen Eingangssignal 10 verschoben, daß nicht das vom D/A-Wandler ausgegebene analoge Signal 30 sondern erst das anschließend verstärkte analoge Signal 40 dem ausgelesenen Originalwert 10 entspricht. Auf diese Weise können durch die Korrekturvorrichtung 100 nicht nur die Fehler der D/A-Wandlung sondern auch die durch die Verstärkung hervorgerufenen Verzerrungen kompensiert werden, so daß das schließlich ausgegebene Audiosignal 40 dem ursprünglich vom Medium eingelesenen Audiosignal 10 möglichst nahe kommt bzw. mit diesem identisch ist.

Die oben beschriebenen Ausführungsbeispiele der vorliegenden Erfindung können insbesondere bei CD-Playern, DVD-Playern, Vorverstärkern, Vollverstärkern, Surround-Prozessoren, digitalen Tunern, DVBT-Tunern, DAB-Tunern, SACD-Playern sowie HD-DVD-Playem vorteilhaft eingesetzt werden. Ebenfalls können das Korrekturverfahren sowie die zugehörige Korrekturvorrichtung bei Abspielgeräten nach dem BluRay^{®}-Standard eingesetzt werden.

Die vorliegende Erfindung wurde anhand von Ausführungsbeispielen erläutert. Diese Ausführungsbeispiele sollten keinesfalls als einschränkend für die vorliegende Erfindung verstanden werden.

## Patentansprüche

1. Verfahren zur Korrektur von Signalverzerrungen, umfassend die Schritte:
(a) Einlesen eines digitalen Eingangssignalwerts,
(b) Bestimmen eines digitalen Ausgangssignalwerts anhand des eingelesenen digitalen Eingangssignalwerts, und
(c) Ausgeben des digitalen Ausgangssignalwerts an eine Signalverarbeitungsstrecke,
wobei in Schritt (b) der digitale Ausgangssignalwert so bestimmt wird, daß ein vorbestimmter systematischer Fehler einer Signalverarbeitung durch die Signalverarbeitungsstrecke bezüglich des digitalen Eingangssignalwerts kompensiert wird.

2. Verfahren nach Anspruch 1, wobei der vorbestimmte systematische Fehler mittels einer Übertragungsfunktion der Signalverarbeitungsstrecke bestimmt wird.

3. Verfahren nach Anspruch 2, wobei die Übertragungsfunktion der Signalverarbeitungsstrecke vor Durchführung der Schritte (a) bis (c) gemessen wird.

4. Verfahren nach einem der vorhergehenden Ansprüche, wobei die digitalen Ausgangssignalwerte in Form einer Look-Up-Tabelle bereitgestellt werden.

5. Verfahren nach Anspruch 4, wobei der digitale Eingangssignalwert als Indexwert der Look-Up-Tabelle verwendet wird.

6. Verfahren nach einem der vorhergehenden Ansprüche, wobei der vorbestimmte systematische Fehler zumindest einen systematischen Fehler einer Wandlung eines digitalen Signalwerts in ein analoges Signal beinhaltet.

7. Verfahren nach Anspruch 6, wobei der systematische Fehler der Wandlung des digitalen Signalwerts in ein analoges Signal einen Offsetfehler und/oder einen Linearisierungsfehler und/oder einen Monotoniefehler umfaßt.

8. Verfahren nach einem der vorhergehenden Ansprüche, weiterhin umfassend den Schritt:
(d) Umwandeln des digitalen Ausgangssignalwerts in ein analoges Signal.

9. Verfahren nach einem der vorhergehenden Ansprüche, wobei der vorbestimmte systematische Fehler zumindest einen systematischen Fehler einer Verstärkung eines aus dem digitalen Ausgangssignal erhaltenen analogen Signals beinhaltet.

10. Verfahren nach Anspruch 9, wobei der systematische Fehler der Verstärkung des analogen Signals eine nichtlineare Verzerrung umfaßt.

11. Verfahren nach einem der vorhergehenden Ansprüche, weiterhin umfassend den Schritt:
(e) Verstärken eines aus dem digitalen Ausgangssignalwert erhaltenen analogen Signals.

12. Verfahren nach einem der vorhergehenden Ansprüche, wobei der digitale Eingangssignalwert ein Audiosignal ist.

13. Vorrichtung (100) zur Korrektur von Signalverzerrungen, umfassend
Mittel (110) zum Einlesen eines digitalen Eingangssignalwerts (10),
Mittel (120) zum Bestimmen eines digitalen Ausgangssignalwerts (20) anhand des eingelesenen digitalen Eingangssignalwerts (10), wobei der digitale Ausgangssignalwert (20) so bestimmt wird, daß ein vorbestimmter systematischer Fehler einer nachfolgenden Signalverarbeitung durch eine
Signalverarbeitungsstrecke bezüglich des digitalen Eingangssignalwerts (10) kompensiert ist, und
Mittel (130) zum Ausgeben des digitalen Ausgangssignalwerts (20) an die Signalverarbeitungsstrecke.

14. Vorrichtung nach Anspruch 13, wobei in dem Mittel (120) zum Bestimmen eines digitalen Ausgangssignalwerts (20) mehrere digitale Ausgangssignalwerte (20) in Form einer Look-Up-Tabelle (1200) bereitgestellt sind.

15. Vorrichtung nach Anspruch 14, wobei die in dem Mittel (100) zum Bestimmen eines digitalen Ausgangssignalwerts (20) bereitgestellte Look-Up-Tabelle (1200) anhand von digitalen Eingangssignalwerten (10) indexiert ist.

16. Vorrichtung nach einem der Ansprüche 13 bis 15, wobei die Vorrichtung ein Mikrocontroller ist.

17. Vorrichtung nach einem der Ansprüche 13 bis 16, weiterhin umfassend eine Abschirmung (200, 210), die eine ungewollte Beeinflussung der Vorrichtung durch ein Taktsignal weitgehend verhindert.

18. Vorrichtung nach Anspruch 17, wobei die Abschirmung ein Metallgehäuse (200) umfaßt.

19. Vorrichtung zum Verarbeiten eines digitalen Audiosignals, umfassend
Mittel (300) zum Bereitstellen eines digitalen Audiosignals (10) an eine Vorrichtung (100) zur Korrektur von Signalverzerrungen,
eine mit diesen Mitteln (300) verbundene Vorrichtung (100) zur Korrektur von Signalverzerrungen gemäß einem der Ansprüche 13 bis 18, eine Signalverarbeitungsstrecke (400, 500) zur Verarbeitung eines von der Vorrichtung (100) zur Korrektur von Signalverzerrungen ausgegebenen digitalen Ausgangssignals (20).

20. Vorrichtung nach Anspruch 19, wobei die Vorrichtung ein CD-Player, ein DVD-Player, ein Vorverstärker, ein Vollverstärker, ein Surround-Prozessor, ein digitaler Tuner, ein DVBT-Tuner, ein DAB-Tuner, ein SACD-PLayer, ein HD-DVD-Player ist.

21. Herstellungsverfahren für eine Vorrichtung zum Verarbeiten eines digitalen Audiosignals gemäß einem der Ansprüche 19 oder 20, umfassend die Schritte:
(a) Bereitstellen eines vorbestimmten Testsignals an eine Signalverarbeitungsstrecke;
(b) Bestimmen eines von der Signalverarbeitungsstrecke anhand des Testsignals erzeugten Ausgangssignals;
(c) Ermitteln eines systematischen Fehlers der Signalverarbeitungsstrecke anhand des Testsignals und des Ausgangssignals;
(d) Bestimmen einer Zuordnung zwischen digitalen Eingangssignalwerten und digitalen Ausgangssignalwerten, so daß der ermittelte systematische Fehler der Signalverarbeitungsstrecke bezüglich des digitalen Eingangssignalwerts durch den digitalen Ausgangssignalwert kompensiert wird, und
(e) Bereitstellen der bestimmten Zuordnung in der Vorrichtung zur Korrektur von Signalverzerrungen.

22. Verfahren nach Anspruch 21, wobei der systematische Fehler mittels einer Übertragungsfunktion der Signalverarbeitungsstrecke bestimmt wird.

23. Verfahren nach Anspruch 21 oder 22, wobei die Zuordnung in Form einer Look-Up-Tabelle bereitgestellt wird.
